(19) **Europäisches Patentamt**
**European Patent Office**
**Office européen des brevets**

(11) **EP 4 318 940 A1**

(12) **EUROPEAN PATENT APPLICATION**

(43) Date of publication:
**07.02.2024 Bulletin 2024/06**

(21) Application number: **22188429.9**

(22) Date of filing: **03.08.2022**

(51) International Patent Classification (IPC):
**H03B 5/12** $^{(2006.01)}$

(52) Cooperative Patent Classification (CPC):
**H03B 5/1212; H03B 5/1228**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **CSEM Centre Suisse d'Electronique et de
Microtechnique SA - Recherche et
Développement
2002 Neuchâtel (CH)**

(72) Inventor: **Manetakis, Konstantinos
2000 Neuchâtel (CH)**

(74) Representative: **P&TS SA (AG, Ltd.)
Avenue J.-J. Rousseau 4
P.O. Box 2848
2001 Neuchâtel (CH)**

(54) **OSCILLATOR AND TRANSCEIVER COMPRISING THIS OSCILLATOR**

(57) The present invention concerns an oscillator (100) arranged to output an oscillator carrier and comprising:
- a tank circuit (20, 30),
- an active circuit (10) connected to the tank circuit (20, 30), the active circuit (10) comprising transistors (T1, T2), each transistor comprising a terminal (B1, B2), said terminal (B1, B2) allowing to modify a threshold voltage of the transistor (T1, T2).

According to the invention, the oscillator (100) comprises a control circuit arranged to modify the voltage at the fourth terminal (B1, B2) of at least a subset of said transistors (T1, T2), so as to minimize a phase difference between the oscillator carrier and a device current of the active circuit (10), thereby minimizing low frequency noise to phase noise conversion.

Fig. 1

## Description

### Technical domain

The present invention concerns an oscillator. The present invention concerns also a transceiver comprising this oscillator.

### Related art

An oscillator is in general used to generate a carrier signal, having a carrier frequency. In general, this carrier frequency is an RF frequency, i.e. a frequency between 3 kHz and 300 GHz, in particular between 300 MHz and 100 GHz.

An oscillator in general comprises:

- a tank circuit, and
- an active circuit (or active device) connected to the tank circuit, the active circuit comprising transistors.

The tank circuit provides a resonant frequency. In general, the tank circuit comprises an inductor and a capacitor, and the oscillator is named "LC-tuned oscillator." It can comprise a common mode part and a differential part and then a differential respectively common-mode tank impedance.

The active circuit allows to sustain the oscillation of the tank circuit. It can be modelled as a nonlinear transconductor G(V):

$$G(V) = g_1 \mathrm{V} + g_2 \mathrm{V}^2 + g_3 \mathrm{V}^3 \tag{1}$$

wherein

V is the differential voltage across the active circuit, which in general correspond to the voltage across the tank circuit
$g_1$ is the first-order transconductance of the active circuit as a whole
$g_2$ is the second-order transconductance of the active circuit as a whole
$g_3$ is the third-order transconductance of the active circuit as a whole.

Low frequency noise is present within the oscillator. In this context the expression "low frequency noise" indicates a noise having a frequency lower than the carrier frequency, e.g. a frequency lower than 100 MHz, in particular between 10Hz and 100 MHz.

This low frequency noise can comprise 1/f noise (or flicker noise) inherent in the active circuit, low frequency noise emanating from the oscillator voltage and/or bias circuitry of the active circuit and/or of the tank circuit.

Non-linear operation of components within the oscillator can up-convert noise present within the oscillator. The up-converted noise can produce phase noise in the carrier signal and noise side bands on either side of the carrier frequency, worsening the oscillator spectral purity and resulting in deteriorated phase noise performance.

In modern submicron processes, low frequency noise to phase noise up-conversion is detrimental, as the low frequency noise corner extends well into the MHz range, thus affecting phase noise up to several MHz from the carrier.

Low-frequency noise to phase noise up-conversion comprises in general two steps.

The first step is the up-conversion of low-frequency noise to the carrier frequency due to the cyclo-stationary nature of the oscillator operation. This is unavoidable if the oscillator active circuit operates under large-signal conditions. The operating region of the active devices in fact varies continuously over the oscillator period. They operate in saturation, triode and cut-off. Their noise density depends on their terminal voltages and currents. As these vary over the oscillator period, so do the statistics of their noise density.

The second step is the conversion of the up-converted low-frequency noise to phase noise. This step is governed by the following phase dynamics equation:

$$\frac{d\theta}{dt} = \omega_0 + \frac{i_n}{AC}\cos(\omega_0 t) \tag{2}$$

wherein:

θ is the oscillator phase

t is the time
$\omega_0$ is the carrier frequency
A is the oscillator carrier (voltage) amplitude
C is the tank capacitance
$i_n$ is the injected noise current.

From the phase dynamics equation (1), it can be shown that the phase noise PN due to transconductor 1/f noise, as well as, due to low-frequency supply/bias noise is given by:

$$PN \sim \frac{\sin \phi}{C^2 A^2 \omega_0^3} \tag{3}$$

wherein:
$\phi$ is phase shift between the oscillator carrier and the transconductor first harmonic current.
The phase shift $\phi$ between the oscillator carrier and the first-order transconductance is given by

$$\phi = \tan^{-1}\left(-\frac{(g_1 R - 1)^2}{8Q}\right) \tag{4}$$

wherein:

R is the tank parallel loss resistance
Q is the tank quality factor.

For the oscillator to start up, the product $(g_1 \cdot R)$ should be higher than one, therefore $\phi$ attains a small positive value, resulting in finite low-frequency noise to phase noise conversion.
Considering common-mode effects, the phase shift $\phi$ becomes

$$\phi = \tan^{-1}\left(-\frac{(g_1 R - 1)^2}{8Q} + \frac{2g_2}{3g_3}(g_1 R - 1) Z_{CMi}(2\omega_0)\right) \tag{5}$$

wherein:
$Z_{CMi}(2\omega_0)$ is imaginary part of the tank common-mode tank impedance $Z_{CM}$ at the oscillator second harmonic $2\omega_0$.
Document US9559702B1 indicates that by properly designing the term $Z_{CMi}(2\omega_0)$, it is possible that $\phi$ attains a small value or a null value, thereby reducing the conversion of low-frequency noise to phase noise.
In practice, however, it is very difficult to predict and thus accurately design the value of the common-mode tank impedance, because the common-mode tank impedance is usually distributed, making its accurate simulation difficult.
Moreover, the possibilities to reduce the low-frequency noise to phase noise conversion after the fabrication of the oscillator are low or null.

**Short disclosure of the invention**

An aim of the present invention is the provision of an oscillator that overcomes the shortcomings and limitations of the state of the art.
Another aim of the invention is provision of an oscillator wherein the conversion of low-frequency noise to phase noise is reduced in a way alternative to the known solutions.
Another aim of the invention is provision of an oscillator wherein the conversion of low-frequency noise to phase noise can be at least partially reduced also after the fabrication of the oscillator.
According to the invention, these aims are attained by the object of the attached claims, and especially by an oscillator arranged to generate an oscillator carrier, the oscillator comprising:

- a tank circuit,
- an active circuit connected to the tank circuit, the active circuit comprising transistors, each transistor comprising a terminal, this terminal allowing to modify a threshold voltage of the transistor.

According to the invention, the oscillator comprises also a control circuit arranged to modify the voltage at the fourth terminal of at least a sub-set of those transistors, so as to minimize a phase difference between a voltage of the oscillator carrier and a current of the active circuit, thereby minimizing low frequency noise to phase noise conversion.

According to the invention, the fourth terminal allows to modify a threshold voltage of at least a sub-set of the transistors of the active circuit. In one embodiment, the fourth terminal is the bulk terminal of those transistor. In another embodiment, in particular if the transistors are realised in the technology silicon on insulator (SIO) or fully depleted silicon on insulator (FDSOI), the fourth terminal is the back gate terminal of the transistors. In another embodiment in which the transistors comprise two gate terminals, the fourth terminal is one of the two gate terminals.

With respect to what is known in the art, the conversion of low-frequency noise to phase noise is reduced in a way which is alternative to the known solutions.

In fact, the applicant has discovered that, it is possible to modify the value of the second-order transconductance $g_2$ in formula (5), by modifying the voltage at the fourth terminal of at least a sub-set of those transistors. This allows to reduce $\phi$ to small values or to a null value, thereby reducing the conversion of low-frequency noise to phase noise.

Advantageously, the modification of the value of the second-order transconductance $g_2$ does not change the amplitude of the generated oscillator carrier. On the contrary, the modification of the value of the first-order transconductance $g_1$ or of the value of the third-order transconductance $g_3$ affects the amplitude of the generated oscillator carrier.

Therefore, according to the invention it is possible to reduce $\phi$ to small values or to a null value, thereby reducing the conversion of low-frequency noise to phase noise, without affecting the amplitude of the generated oscillator carrier.

Thanks to the applicant's discovery, it is possible to perform a control of the term $g_2$ in formula (5), without having to accurately predict the value of the tank common-mode impedance at the oscillator second harmonic $Z_{CMi}(2\omega_0)$.

Most importantly, this control can be performed even post fabrication, without modifying the hardware of the oscillator according to the invention. In fact, this modification can be implemented by an algorithm executed by the control circuit of the oscillator according to the invention.

The skilled person, facing the problems mentioned above, would not be incited to modify the voltage at the fourth terminal of at least a sub-set of the transistors of the active circuit, in order to reduce the conversion of low-frequency noise to phase noise, for a number of reasons. First, the skilled person does not know that it exists a relation between the value of the second-order transconductance $g_2$ and the voltage at the fourth terminal of at least a sub-set of the transistors of the active circuit. Second, the skilled person is not incited to modify the voltage at the fourth terminal of those transistors, as this changes the threshold voltage of those transistors, which in general is not desirable. Third, in general it is recommended to connect the fourth terminal to the source terminal, thereby avoiding its control. In fact, between the source terminal and the bulk terminal (as well as between the drain terminal and the bulk terminal) there is a diode and it is desirable that it is not forwarded biased, for avoiding the conduction of an unwanted current.

In one embodiment, the control circuit is arranged to modify the voltage at the fourth terminal of all the transistors of the active circuit.

In one embodiment, at least the sub-set of the transistors of the active circuit, and preferably all the transistors of the active circuit, is(are) realised in the technology fully depleted silicon on insulator (FDSOI) or in the technology deeply depleted channel (DDC).

In one embodiment, the control circuit comprises (at least one) digital to analog converter (DAC) whose output is connected to each fourth terminal of at least the sub-set of the transistors of the active circuit, and a decoupling capacitor between the DAC's output and ground. This embodiment allows to carefully control the voltage at each fourth terminal of at least the sub-set of the transistors of the active circuit, by shunting the extra-noise to ground thanks to the decoupling capacitor, thereby avoiding to affect the working of the transistors.

In one embodiment, the tank circuit comprises a common mode part and a differential part.

In one embodiment, the common mode part is modeled as a common inductor between a supply node and a common node, and a common capacitor between the common node and the ground.

In one embodiment, the differential part comprises an inductor, a capacitor and a resistor, the inductor, the capacitor and the resistor being in parallel. In one embodiment, this resistor models the differential tank loss.

In one embodiment, the oscillator is a voltage-biased oscillator.

In one embodiment, the oscillator is a current-biased oscillator.

In one embodiment, the active circuit comprises a crossed coupled pair of transistors.

The present invention concerns also a transceiver comprising:

- a transmitting path, comprising the oscillator according to the invention,
- a receiving path.

In one embodiment, the transceiver is a radio-frequency (RF) transceiver.

In this context the term "RF" or the expression "radio-frequency" indicates a range of frequencies between 3 kHz and 300 GHz, in particular between 300 MHz and 100 GHz.

RF transceivers are well known and widely used, in communication devices (e.g., in portable or wearable devices), to perform signal transmission and reception over one or multiple frequency bands according to communication standards, as for example Bluetooth (BT), Bluetooth Low Energy (BLE), WCDMA, CDMA, GSM, LTE standards for cellular telephony, IEEE 802.11 protocols for wireless LAN, etc.

In one embodiment, the transceiver comprises a single (RF) antenna port common to transmitting path and the receiving path. The presence of a single (RF) antenna port common is not essential and the transceiver could comprise instead two (or more) antenna ports.

In one embodiment,

- the transmitting path comprises:

    - a phase-locked loop, the oscillator being connected to the output of the phase-locked loop, the output of the oscillator being an input of the phase-locked loop,
    - a divider, arranged to divide the frequency of the oscillator carrier by a number, and being connected to the output of the oscillator,
    - a power amplifier, connected to an output of the divider,

- the receiving path comprises:

    - a low noise amplifier,
    - two mixers, each mixer being connected to the output of the low noise amplifier, one of the mixer being connected to a first output of the divider, and the other mixer being connected to a second output of the divider
    - an analog and digital base-band circuit, connected to the output of each mixer,

- a switch connecting output of the power amplifier to the input of the low noise amplifier,

the transceiver comprises a transceiver control circuit, arranged to:

- close said switch, thereby creating a loopback path between the transmitting path and the receiving path,
- inject a low-frequency tone at a supply of said oscillator, thereby generating up-converted tones around the oscillator carrier,
- recover at the digital base-band circuit the amplitude of the up-converted tones
- sweep the voltage at the fourth terminal of the active circuit transistors, so as to minimize the amplitude of the up-converted tones, thereby calibrating the oscillator to reduce the low-frequency to phase-noise conversion.

This embodiment allows to calibrate the oscillator to reduce the low-frequency to phase-noise conversion without adding or using new components to the transceiver, but by implementing a specific algorithm by transceiver control circuit.

In one embodiment, the transceiver control circuit is arranged to perform those steps at a start-up phase of the transceiver.

Short description of the drawings

Exemplar embodiments of the invention are disclosed in the description and illustrated by the drawings in which:

Figure 1 illustrates schematically an oscillator according to an embodiment of the invention.

Figure 2 illustrates schematically an oscillator according to another embodiment of the invention.

Figure 3 illustrates schematically a portion of the oscillator according to another embodiment the invention.

Figure 4 illustrates schematically a transceiver comprising an oscillator according to an embodiment of the invention.

**Examples of embodiments of the present invention**

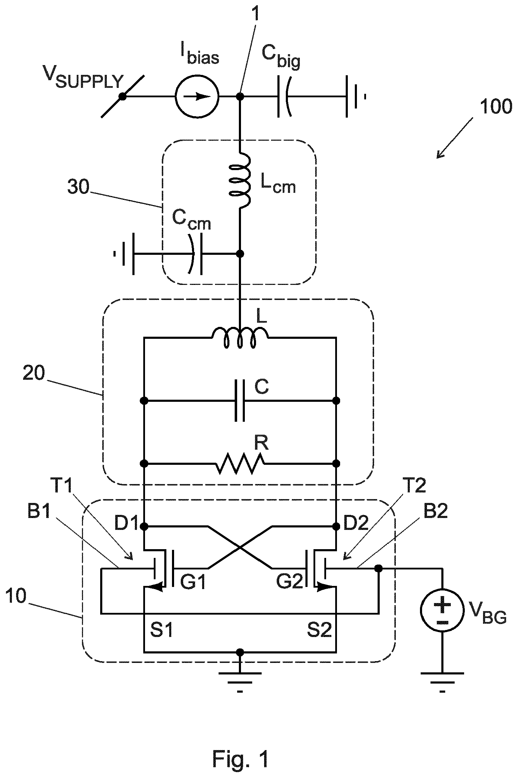

Figure 1 illustrates schematically an oscillator 100 according to an embodiment of the invention. The oscillator 100 is a current-biased oscillator. It comprises:

- a tank circuit, comprising a common mode part 30 and a differential part 20, and
- an active circuit 10 connected to the tank circuit, the active circuit comprising transistors T1 and T2.

The common mode part 30 of the tank circuit is modeled as a common inductor $L_{cm}$ between a supply node and a common node 1, and a common capacitor $C_{cm}$ between the common node and the ground.

The differential part 20 of the tank circuit comprises a (differential mode) inductor L, a (differential mode) capacitor C and a (differential mode) resistor R modelling differential tank losses. The inductor L, the capacitor C and the resistor R are in parallel.

The active circuit 10 of Figure 1 comprises a crossed coupled pair of transistors T1 and T2. Each transistor T1, T2 comprises four terminals, i.e.:

- a first terminal,
- a second terminal,
- a third terminal, and
- a fourth terminal.

In the context of the present invention, the term "terminal" must be considered as a synonym of a node. It does not necessarily indicate that it is a pin that can be physically accessed by a user.

In one embodiment, the first terminal is the drain terminal, the second terminal is a gate terminal, and the third terminal is the source terminal of the transistor. According to the invention, the fourth terminal allows to modify a threshold voltage of the transistor. Then, in one embodiment, the fourth terminal is the bulk terminal of the transistor. In another embodiment, in particular if the transistor is realised in the technology silicon on insulator (SIO) or fully depleted silicon on insulator (FDSOI), the fourth terminal is the back gate terminal of the transistor. In another one embodiment in which the transistor comprises two gate terminals, the fourth terminal is one of the two gate terminals.

Since the active device 10 of Figure 1 comprises a crossed coupled pair of transistors T1 and T2, the gate terminal G1 of the transistor T1 is connected to the drain terminal D2 of the transistor T2 and vice-versa.

In the embodiment of Figure 1, the source terminals S1 and S2 are connected together and grounded.

In the embodiment of Figure 1, the transistors T1 and T2 are N-type transistors. However, the invention is not limited to the use of N-type transistors and applies also to P-type transistors.

In the embodiment of Figure 1, the fourth terminals B1 and B2 are connected together and set to a voltage $V_{BG}$ which can be controlled or modified by a control circuit (not illustrated). Although the connection of the fourth terminals of the active circuit 10 according to the invention allow a simplified control of their voltage, this feature is not essential and the fourth terminals of the active circuit 10 could be controlled separately, without the need to connect them together.

According to the invention, the control circuit (not illustrated) is arranged to modify the voltage at the fourth terminal B1, B2, so as to minimize a phase difference between a voltage of the oscillator carrier and a current of the active circuit 10, thereby minimizing low frequency noise to phase noise conversion.

In other words, by properly setting the voltage at the fourth terminals B1, B2, it's possible to minimize low-frequency to phase conversion even if the tank common-mode impedance at the oscillator second harmonic $Z_{CMi}(2\omega_0)$ is not optimally predicted.

In fact, the applicant has discovered that, it is possible to modify the value of the second-order transconductance $g_2$ in formula (5), by modifying the voltage at the fourth terminal of at least a sub-set of those transistors. This allows to reduce $\phi$ to small values or to a null value, thereby reducing the conversion of low-frequency noise to phase noise.

Advantageously, the modification of the value of the second-order transconductance $g_2$ does not change the amplitude of the generated oscillator carrier. On the contrary, the modification of the value of the first-order transconductance $g_1$ or of the value of the third-order transconductance $g_3$ affects the amplitude of the generated oscillator carrier.

Therefore, according to the invention it is possible to reduce $\phi$ to small values or to a null value, thereby reducing the conversion of low-frequency noise to phase noise, without affecting the amplitude of the generated oscillator carrier.

Most importantly, this control can be performed even post fabrication, without modify the hardware of the oscillator according to the invention. In fact, this modification can be implemented by an algorithm executed by the control circuit of the oscillator according to the invention.

In one embodiment, the transistors T1, T2 of the active circuit, is(are) realised in the technology fully depleted silicon on insulator (FDSOI) or in the technology deeply depleted channel (DDC).

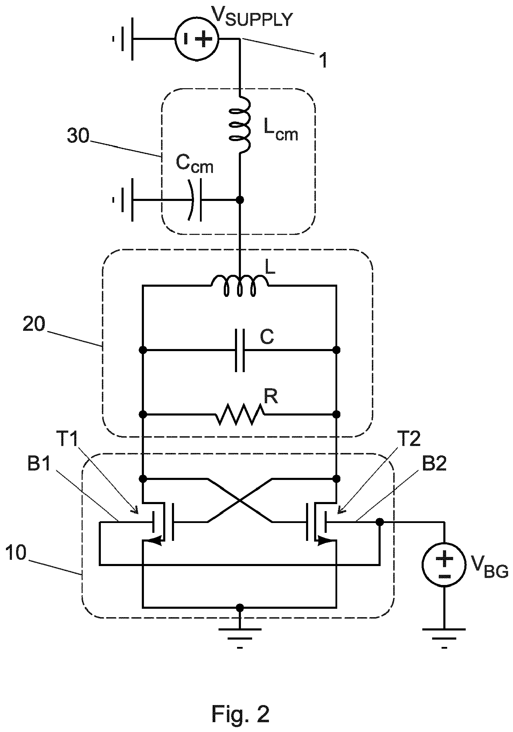

Figure 2 illustrates schematically an oscillator 100 according to another embodiment of the invention. The only difference between the oscillator of Figure 1 and the oscillator of Figure 2 is that the oscillator of Figure 2 is a voltage-biased oscillator.

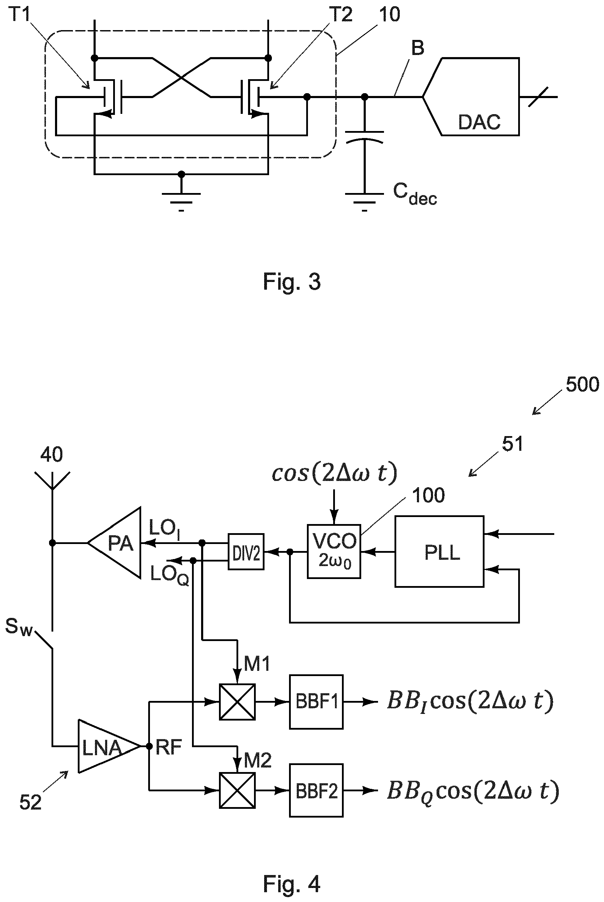

Figure 3 illustrates schematically a portion of the oscillator according to another embodiment the invention. In this embodiment, the control circuit comprises a digital to analog converter DAC whose output is connected to each fourth terminal B of the transistors of the active circuit 10, and a decoupling capacitor $C_{dec}$ between the DAC's output and ground. This embodiment allows to carefully control the voltage at each fourth terminal of at least the sub-set of the transistors of the active circuit, by shunting the extra-noise to ground thanks to the decoupling capacitor, thereby avoiding to affect the working of the transistors.

In the embodiment of Figure 3, the fourth terminals of the transistors of the active circuit 10 are connected together. Again, although the connection of the fourth terminals of the active circuit 10 according to the invention allow a simplified control of their voltage, this feature is not essential and the fourth terminals of the active circuit 10 could be controlled separately, e.g. with a single DAC (as in Figure 3) or via multiple DACs, e.g. one for each fourth terminal. However, those last embodiments are less used, for the (high) number of their components.

Figure 4 illustrates schematically a transceiver 500 comprising:

- a transmitting path 51, comprising the oscillator 100 according to the invention, and
- a receiving path 52.

In one preferred embodiment, the transceiver 500 is a radio-frequency (RF) transceiver.

In one embodiment, the transceiver comprises a single (RF) antenna port 40 common to transmitting path 51 and the receiving path 52.

In the embodiment of Figure 4, the transmitting path 51 comprises:

- a phase-locked loop PLL, the oscillator 100 being connected to the output of the phase-locked loop PLL, the output of the oscillator 100 being an input of the phase-locked loop PLL,
- a divider DIV2, arranged to divide the frequency of the oscillator carrier by a number, and being connected to the output of the oscillator 100,
- a power amplifier PA, connected to an output of the divider DIV2.

In the embodiment of Figure 4, the divider DIV2 is arranged to output two signals $LO_I$ and $LO_Q$, the two signals being in quadrature.

In the embodiment of Figure 4, the receiving path 52 comprises:

- a low noise amplifier LNA,
- two mixers M1, M2, each mixer being connected to the output of the low noise amplifier LNA, one of the mixer M1 being connected to a first output of the divider $LO_I$, and the other mixer M2 being connected to a second output of the divider $LO_Q$,
- an analog and/or digital base-band circuit, comprising base-band filters BBF1, BBF2, each base-band filter being connected to an output of each mixer.

In the embodiment of Figure 4, the transceiver 500 comprises also a switch Sw connecting the output of the power amplifier PA to the input of the low noise amplifier LNA.

The transceiver 500 of Figure 4 comprises also a transceiver control circuit (not illustrated), arranged to:

- close said switch, thereby creating a loopback path between the transmitting path 51 and the receiving path 52,
- inject a low-frequency tone (in the example, cos(2Δωt)), thereby generating up-converted tones around the oscillator carrier.

Δω indicates a frequency much lower than the carrier frequency, e.g. a frequency lower than 100 MHz, in particular between 10 Hz and 100 MHz,.

In the embodiment of Figure 4, the divider DIV2 is arranged to divide by two. However, this number should not be considered as limitative. In one embodiment, if the low-frequency tone is cos(NΔωt)), then the divider DIV2 is arranged to divide the input by N, N being an integer positive number.

The oscillator carrier becomes after the DIV2

$$LO_I = A\cos(\omega_o t) \pm \alpha \cos[(\omega_o \pm \Delta\omega)t + \psi] \qquad (6)$$

$$LO_Q = -A\sin(\omega_o t) \mp \alpha \sin[(\omega_o \pm \Delta\omega)t + \psi] \qquad (7)$$

wherein a is the amplitude of the up-converted tones.

The signal at the LNA output (via the loopback path, i.e., when the switch Sw is closed) becomes:

$$RF = A\cos(\omega_o t + \varphi) \pm \alpha \cos[(\omega_o \pm \Delta\omega)t + \psi + \varphi] \tag{8}$$

wherein

$\varphi$ is the phase shift between the PA output signal and the LNA input signal

$\psi$ is the phase difference between the up-converted tones and the carrier.

Looking at the base-band at frequency $2\Delta\omega$ (or in general $N\Delta\omega$) it is possible to retrieve the following signals $BB_I$ and $BB_Q$:

$$BB_I = \alpha^2 \cos(\varphi) \tag{9}$$

$$BB_Q = \alpha^2 \sin(\varphi) \tag{10}$$

At the digital base-band circuits following the base-band filters BBF1 and BBF2, it is possible to process the signals $BB_I$ and $BB_Q$ e.g., according to the following formula:

$$BB_I{}^2 + BB_Q{}^2 \tag{11}$$

in order to recover a with any dependency from $\varphi$.

Calibration can thus be done by minimizing $\alpha$ while sweeping the voltage at the fourth terminal of the active circuit of the oscillator 100, so as to minimize the amplitude $\alpha$ of the up-converted tones, thereby calibrating the oscillator 100 to reduce the low-frequency to phase-noise conversion.

This calibration is performed at the start-up of the transceiver 500.

Advantageously, this calibration does not require any additional hardware for the transceiver 500, but it is performed by the transceiver control circuit.

**Reference signs used in the figures**

| | |
|---|---|
| 1 | Common node |
| 10 | Active circuit |
| 20 | Differential part of the circuit tank |
| 30 | Common mode part of the circuit tank |
| 40 | Antenna port |
| 51 | Transmitting path |
| 52 | Receiving path |
| 100 | Oscillator |
| 500 | Transceiver |
| B, B1, B2 | Fourth terminal |
| BFF | Base-band filter |
| C | Capacitor |
| $C_{big}$ | (Big) capacitor |
| $C_{cm}$ | Common mode capacitor |
| $C_{dec}$ | Decoupling capacitor |
| D1, D2 | Drain terminal |
| DAC | Digital to Analog Converter |
| DIV | Divider |
| G1, G2 | Gate terminal |

| $I_{bias}$ | Bias current |
|---|---|
| L | Inductor |
| $L_{cm}$ | Common mode inductor |
| LNA | Low Noise Amplifier |
| M1, M2 | Mixer |
| PA | Power Amplifier |
| PLL | Phase-locked loop |
| R | Resistor |
| S1, S2 | Source terminal |
| Sw | Switch |
| T1, T2 | Transistor |
| $V_{BG}$ | Fourth terminal-gate terminal tension |
| $V_{SUPPLY}$ | Supply tension |
| VCO | Oscillator |

**Claims**

1. An oscillator (100) arranged to output an oscillator carrier, the oscillator comprising:

   - a tank circuit (20, 30),
   - an active circuit (10) connected to the tank circuit (20, 30), the active circuit (10) comprising transistors (T1, T2), each transistor comprising a terminal (B1, B2), said terminal (B1, B2) allowing to modify a threshold voltage of the transistor (T1, T2),

   **characterised in that** the oscillator comprises

   - a control circuit arranged to modify the voltage at the fourth terminal (B1, B2) of at least a subset of said transistors (T1, T2), so as to minimize a phase difference between the oscillator carrier and a device current of the active circuit (10), thereby minimizing low frequency noise to phase noise conversion.

2. The oscillator (100) of claim 1, wherein the control circuit is arranged to modify the voltage at the fourth terminal (B1, B2) of all said transistors (T1, T2).

3. The oscillator of one of claims 1 or 2, wherein at least the sub-set of said transistors (T1, T2) is realised in the technology fully depleted silicon on insulator (FDSOI) or in the technology deeply depleted channel (DDC).

4. The oscillator (100) of claim 3, wherein all said transistors (T1, T2) are realised in the technology fully depleted silicon on insulator (FDSOI) or in the technology deeply depleted channel (DDC).

5. The oscillator of one of claims 1 to 4, wherein the control circuit comprises at least one digital-to-analog converter (DAC) whose output is connected to each fourth terminal of the sub-set of said transistors, and a decoupling capacitor between the DAC's output and a ground.

6. The oscillator of one of claims 1 to 5, the tank circuit comprising a common mode part (30) and a differential part (20).

7. The oscillator of claim 6, wherein the common mode part (30) is modeled as a common inductor ($L_{cm}$) between a supply node and a common node, and a common capacitor ($C_{cm}$) between the common node and the ground.

8. The oscillator of one of claims 6 to 7, wherein the differential part (20) comprises an inductor (L), a capacitor (C) and a resistor (R), the inductor (L), the capacitor (C) and the resistor (R) being in parallel.

9. The oscillator of one of claims 1 to 8, the oscillator being a voltage-biased oscillator.

10. The oscillator of one of claims 1 to 9, the oscillator being a current-biased oscillator.

11. The oscillator of one of claims 1 to 10, the active circuit comprising a crossed coupled pair of transistors (T1, T2).

**12.** A transceiver (500) comprising:

- a transmitting path (51), comprising:

- the oscillator (100) of one of claims 1 to 11,

- a receiving path (52).

**13.** The transceiver (500) of claim 12, comprising a single antenna port (40) common to transmitting path (51) and the receiving path (52).

**14.** The transceiver (500) of one of claims 12 to 13, wherein

- the transmitting path (51) comprises:

- a phase-locked loop (PLL), the oscillator (100) being connected to an output of the phase-locked loop (PLL), an output of the oscillator (100) being an input of the phase-locked loop (PLL),
- a divider (DIV2), arranged to divide the frequency of the oscillator (100) carrier by a number, and being connected to the output of the oscillator (100),
- a power amplifier (PA), connected to an output of the divider (DIV2),

- the receiving path (52) comprises:

- a low noise amplifier (LNA),
- two mixers (M1, M2), each mixer (M1, M2) being connected to the output of the low noise amplifier (LNA), one of the mixer (M1) being connected to a first output ($LO_I$) of the divider (DIV2), and the other mixer (M2) being connected to a second output ($LO_Q$) of the divider (DIV2),
- an analog and digital base-band circuit, connected to the output of the each mixer (M1, M2),

- a switch (Sw) connecting output of the power amplifier (PA) to the input of the low noise amplifier (LNA),

a transceiver control circuit, arranged to perform the following steps:

- close said switch (Sw), thereby creating a loopback path between the transmitting path (51) and the receiving path (52),
- inject a low-frequency tone at a supply of said oscillator (100), thereby generating up-converted tones around the oscillator carrier,
- recover at the digital base-band circuit the amplitude of the up-converted tones,
- sweep the voltage at the fourth terminal (B1, B2) of the active circuit transistors (T1, T2), so as to minimize the amplitude of the up-converted tones, thereby calibrating the oscillator to reduce the low-frequency to phase-noise conversion.

**15.** The transceiver (500) of claim 14, wherein transceiver control circuit is arranged to perform said steps at a start-up phase of said transceiver (500).

Fig. 1

Fig. 2

Fig. 3

Fig. 4

Europäisches
Patentamt

European
Patent Office

Office européen
des brevets

**EUROPEAN SEARCH REPORT**

Application Number

EP 22 18 8429

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/228060 A1 (KÄMPE ANDREAS [SE]) 16 July 2020 (2020-07-16) * paragraph [0049]; figures 2, 7 * | 1-5,9-13 | INV. H03B5/12 |
| X | US 2017/257063 A1 (GONZALEZ J J; GONZALEZ JIMENEZ J; LARIE A; MARTINEAU B) 7 September 2017 (2017-09-07) * paragraph [0042]; figure 3 * | 1-5,9-11 | |
| X | EP 2 079 162 A1 (INFINEON TECHNOLOGIES AG [DE]) 15 July 2009 (2009-07-15) * paragraph [0047]; figure 6C * * paragraph [0065] – paragraph [0067] * | 1-9, 11-13 | |
| A | US 10 942 255 B2 (GLOBALFOUNDRIES US INC [US]) 9 March 2021 (2021-03-09) * paragraph [0021]; figure 2 * | 14,15 | |

TECHNICAL FIELDS
SEARCHED (IPC)

H03B

The present search report has been drawn up for all claims

| Place of search | Date of completion of the search | Examiner |
|---|---|---|
| Munich | 17 January 2023 | Schnabel, Florian |

EPO FORM 1503 03.82 (P04C01)

## ANNEX TO THE EUROPEAN SEARCH REPORT
## ON EUROPEAN PATENT APPLICATION NO.

EP 22 18 8429

This annex lists the patent family members relating to the patent documents cited in the above-mentioned European search report.
The members are as contained in the European Patent Office EDP file on
The European Patent Office is in no way liable for these particulars which are merely given for the purpose of information.

17-01-2023

| Patent document cited in search report | | Publication date | Patent family member(s) | | Publication date |
|---|---|---|---|---|---|
| US 2020228060 | A1 | 16-07-2020 | EP | 3676957 A1 | 08-07-2020 |
| | | | US | 2020228060 A1 | 16-07-2020 |
| | | | WO | 2019045605 A1 | 07-03-2019 |
| US 2017257063 | A1 | 07-09-2017 | EP | 3217542 A1 | 13-09-2017 |
| | | | FR | 3048569 A1 | 08-09-2017 |
| | | | US | 2017257063 A1 | 07-09-2017 |
| EP 2079162 | A1 | 15-07-2009 | EP | 2079162 A1 | 15-07-2009 |
| | | | EP | 2605401 A2 | 19-06-2013 |
| | | | US | 2009179695 A1 | 16-07-2009 |
| US 10942255 | B2 | 09-03-2021 | CN | 111048504 A | 21-04-2020 |
| | | | DE | 102019213841 A1 | 16-04-2020 |
| | | | TW | 202036025 A | 01-10-2020 |
| | | | US | 2020116823 A1 | 16-04-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9559702 B1